# EUROPÄISCHE PATENTANMELDUNG

(11) **EP 4 647 953 A1**
(43) Veröffentlichungstag der Anmeldung: **12.11.2025**
(21) Anmeldenummer: 24174675.9
(22) Anmeldetag: 07.05.2024
(51) Int. Cl.: G06F 30/13

(54) **PLANER FÜR ELEKTROINSTALLATION**

(71) Anmelder: Syngesa GmbH, 47918 Toenisvorst (DE)
(72) Erfinder: Schaepers, Stephan, 47918 Toenisvorst (DE); Schaepers, Leon, 41569 Rommerskirchen (DE)
(74) Vertreter: Rausch, Michael

(57) **Zusammenfassung**

Um ein Verfahren und ein System zur Erstellung eines Planes für eine Elektroinstallation in wenigstens einem Raum bereitzustellen, welches automatisch einen Plan für vorgegebene Räumlichkeiten erstellt, wird mit der Erfindung vorgeschlagen ein Verfahren zur automatischen Erstellung eines Planes für eine Elektroinstallation in wenigstens einem Raum, unter Nutzung eines Systems, welches über eine Rechnereinheit verfügt mit einer Speichereinheit, auf der eine Datenbank mit Vorlagen von Elektroinstallationen für Raumtypen gespeichert ist, und mit Ein- und Ausgabeeinheiten, wobei eine digitalisierte Version der räumlichen Dimensionierungen des Raumes, für den der Plan erstellt werden soll, erfasst und mit den in der Datenbank vorhandenen Raumtypen verglichen wird, eine geeignete Vorlage ausgewählt und auf die konkreten räumlichen Dimensionierungen des Raumes angepasst wird und eine digitale Version der räumlichen Dimensionierungen des Raumes mit der angepassten Elektroinstallation aus der Vorlage versehen und als Datei gespeichert wird.

## Beschreibung

Die vorliegende Erfindung betrifft ein Verfahren zur automatischen Erstellung eines Planes für eine Elektroinstallation in wenigstens einem Raum.

Bei Gebäudeneubauten und umfassenden Renovierungen gehört die Planung der Elektroinstallation zu den grundlegenden Arbeiten. Ist die Planung fertig, sind ausgehend vom Stromanschluss des Gebäudes jede Sicherung, jede Leitung und jede elektrische Installationseinheit wie Schalter, Steckdosen, Wassererhitzer, Lüftungen und dergleichen bekannt. Dazu gehört auch der Aufbau der sogenannten Verteilungen, also der Sicherungskästen im Bereich der Stromzähler oder Unterverteilungen. Diese Planung setzt entsprechende Fachkenntnisse voraus und ist vergleichsweise teuer.

Betrachtet man die Ausstattungen von Gebäuden in einer gewichteten, gegebenenfalls statistischen Weise, so lässt sich feststellen, dass auf eine sehr große Anzahl von Räumen eine im wesentlichen gleichartige Elektroinstallation angewendet wird. Differenziert man Räumlichkeiten nach Funktionalitäten wie Büro, Bäder, Küchen, Werkstatt, Wohnraum, Schlafraum und dergleichen, so lassen sich auch die entsprechenden häufig sehr ähnlichen Elektroinstallationen typisieren.

Dies wird deutlich, betrachtet man den Markt der entsprechenden Installationseinheiten. Die Anbieter haben ein Standardprogramm, welches sich in den üblichen Elektroinstallationen wiederfindet.

Zwar gibt es digitale Konstruktionsprogramme, die es erlauben, in einen vorliegenden Grundriss beispielsweise Installationseinheiten herein zu kopieren, hierbei handelt es sich jedoch ebenso wie die übliche Planung der Elektroinstallation um eine händische Tätigkeit, die vom Endbenutzer oder einem Fachmann vorzunehmen ist.

Ausgehend vom vorbeschriebenen Stand der Technik liegt der vorliegenden Erfindung die Aufgabe zugrunde, ein Verfahren und ein System zur Erstellung eines Planes für eine Elektroinstallation in wenigstens einem Raum bereitzustellen, welches automatisch einen Plan für vorgegebene Räumlichkeiten erstellt.

Zur technischen Lösung dieser Aufgabe schlägt die Erfindung ein Verfahren mit den Merkmalen des Patentanspruches eins vor. Weitere Vorteile und Merkmale ergeben sich aus den Unteransprüchen. Die technische Lösung für ein System ergibt sich aus Patentanspruch 10.

Gemäß der Erfindung umfasst das Verfahren zur automatischen Erstellung eines Planes für eine Elektroinstallation in wenigstens einem Raum die Nutzung eines Systems, welches über eine Rechnereinheit verfügt mit einer Speichereinheit, auf der eine Datenbank mit Vorlagen von Elektroinstallationen für Raumtypen gespeichert ist, und mit Ein- und Ausgabeeinheiten.

Von diesem System wird verfahrensgemäß eine digitalisierte Version der räumlichen Dimensionierungen des Raumes, für den der Plan erstellt werden soll, erfasst und mit den in der Datenbank vorhandenen Raumtypen verglichen. Es wird eine geeignete Vorlage ausgewählt und auf die konkreten räumlichen Dimensionierungen des Raumes angepasst. Schließlich wird eine digitale Version der räumlichen Dimensionierungen des Raumes mit der angepassten Elektroinstallation aus der Vorlage versehen und als Datei gespeichert. Die digitalen Informationen, die einen Raum beschreiben, sind in erster Linie die technischen Maße. Diese umfassen die Länge, Breite, Höhe, Positionen von Türen, Fenstern, Durchgängen, Nischen, deren Höhen, feste Einbauten und dergleichen. Die digitale Auswertung von Grundrisszeichnungen ist in der Architektur ein Standardverfahren.

Bei der Elektrifizierung geht es grundsätzlich darum, einerseits in Bezug auf einen gegebenen Raum den Hauptanschluss zu identifizieren, d.h., den Ort, den man in Bezug auf den Raum als Stromquelle bezeichnen kann, und die jeweiligen Verbrauchstellen ebenso wie erforderliche Kontroll- bzw. Steuerungs-Positionen, wobei es sich in der Regel um Schalter handelt. Für die Positionierung beispielsweise von Steckdosen, Schaltern, Anschlussstellen und dergleichen gibt es häufig standardisierte und/oder gesetzliche Vorgaben. Besonderheiten ergeben sich aus individuellen Planungen, beispielsweise in Bezug auf gewünschte Licht-Anschlussstellen und dergleichen. Sind all diese Positionen ermittelt bzw. bekannt, lassen sich unter Berücksichtigung der bekannten räumlichen Dimensionierungen die optimalen Verläufe von Leitungen ermitteln.

Mit der Erfindung wird verfahrensgemäß lediglich eine räumliche Dimensionierung vorgegeben. Gemäß einem vorteilhaften Vorschlag der Erfindung werden hierfür Grundrisse verwendet. Dies hat den Vorteil, dass diese maßstabgetreu sind und auf diese Weise Leitungslängen und Verläufe sowie die Positionierung von Installationseinheiten maßstabsgetreu ermittelt und dargestellt werden können.

Gemäß der Erfindung kann der Plan für eine Elektroinstallation für eine Gebäudeeinheit erstellt werden. Es können ganze Einfamilienhäuser, Mehrfamilienhäuser, Bürogebäude, Industriegebäude oder auch nur einzelne Räume oder Raumgruppen in das Planungsverfahren Eingang finden. Erfindungsgemäß kann vorgesehen sein, dass bei der Planung zusätzliche Daten wie Raumhöhe, Öffnungen durch Türen, Fenster, Lüftungen und dergleichen sowie vorgesehene Funktionalitäten des Raumes berücksichtigt werden.

Die als Vorgaben gespeicherten Elektroinstallation sind gewissermaßen Standardinstallationen. Das Verfahren erlaubt es, auch individuelle Vorgaben zu berücksichtigen. Schließlich kann vorgesehen sein, dass der gespeicherte Plan fachmännisch überprüft und aktualisiert wird.

Gemäß einem weiteren vorteilhaften Vorschlag der Erfindung werden erstellte Pläne als Vorlagen in die Datenbank übernommen. Dadurch wird die Anwendungsbreite des erfindungsgemäßen Verfahrens automatisch erweitert.

Für den Zweck der praktischen Umsetzung kann gemäß einem Vorschlag der Erfindung vorgesehen sein, dass der Plan für die Elektroinstallation als Zeichnung mit Symbolen für Leitungen und elektrische Funktionseinheiten wie Schalter, Steckdosen, Sicherungen erstellt wird. Dieser kann dann entsprechenden Installateuren direkt als Arbeitsgrundlage dienen.

Gemäß einem vorteilhaften Vorschlag der Erfindung wird der Plan für die Elektroinstallation um eine Stückliste ergänzt. Dies eröffnet die weitere Möglichkeit, dass die Stückliste verwendet wird, um automatisch Preisinformationen von vorgegebenen Bezugsquellen zu ergänzen. Das erfindungsgemäße Verfahren wird dadurch in die Lage versetzt, nicht nur eine Planung für eine Elektroinstallation bereitzustellen, sondern direkt Preisvergleiche für die Gesamtinstallation zu erstellen. Dazu kann entweder die Datenbank um entsprechende Bezugsquellen- und Preisinformationen ergänzt werden, oder es besteht die Möglichkeit, die Stücklisten direkt mit den Preisinformationen auf den digitalen Angebotsseiten der Anbieter abzugleichen.

Gemäß einem weiteren vorteilhaften Vorschlag der Erfindung kann die Datenbank in gleicher Weise um Informationen über potentielle Installateure ergänzt werden, beispielsweise mit geographischer Zuordnung oder Informationen zur Qualifikation.

Die Erfindung schlägt weiterhin vor ein System zur automatischen Erstellung eines Planes für eine Elektroinstallation in wenigstens einem Raum, wobei das System über eine Rechnereinheit verfügt mit einer Speichereinheit, auf der eine Datenbank mit Vorlagen von Elektroinstallationen für Raumtypen gespeichert ist, und mit Ein- und Ausgabeeinheiten, wobei das System eine digitalisierte Version der räumlichen Dimensionierungen des Raumes, für den der Plan erstellt werden soll, erfasst und mit den in der Datenbank vorhandenen Raumtypen vergleicht, eine geeignete Vorlage ausgewählt und auf die konkreten räumlichen Dimensionierungen des Raumes anpasst und eine digitale Version der räumlichen Dimensionierungen des Raumes mit der angepassten Elektroinstallation aus der Vorlage versieht und als Datei speichert. Dieses System kann um alle vorgenannten vorteilhaften Merkmale ergänzt werden.

Gemäß einem weiteren vorteilhaften Vorschlag der Erfindung wird das Verfahren über ein über das Internet erreichbares Portal zugänglich gemacht. Zu diesem Zweck kann es um die üblichen betriebswirtschaftlichen Randmaßnahmen wie Erfassung der Nutzer, Rechnungs- und Bezahlvorgänge und dergleichen ergänzt werden. Das zugrunde liegende System wird vorzugsweise auf Zentralrechnern geführt und gewartet und regelmäßig ergänzt.

Mit der Erfindung wird ein einfach realisierbares Verfahren zur automatischen Erstellung eines Planes für eine Elektroinstallation in gegebenen Räumlichkeiten vorgeschlagen, welches den wirtschaftlichen Aufwand in Bezug auf die Elektroinstallation insgesamt zu reduzieren geeignet ist.

Weitere Vorteile und Merkmale der Erfindung ergeben sich aus der folgenden Beschreibung anhand der Figuren. Dabei zeigen:
- Figur 1 :: eine Darstellung eines typischen Grundrisses und
- Figur 2 :: ein beispielhaftes Flussdiagramm zur Erläuterung der Abläufe.

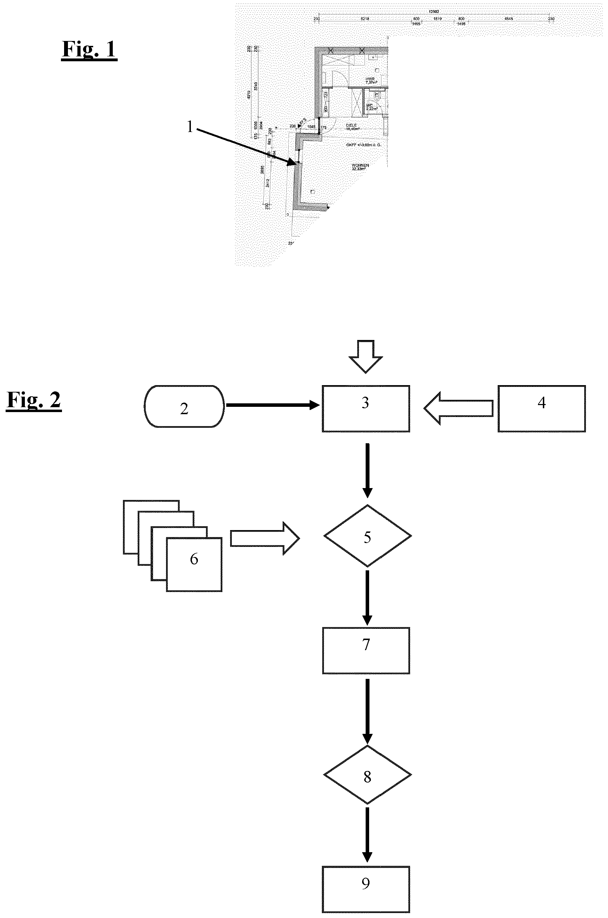

Figur 1 zeigt ein Teil eines typischen Grundrisses 1. Üblicherweise ergeben sich aus derartigen Zeichnungen Informationen über die Räumlichkeiten, deren relative Positionierung und deren Dimensionierungen. Es ist bekannt, derartige Grundrisse in digitale Formate zu bringen, die für Rechneranlagen verarbeitbar sind. Sofern zusätzliche Informationen beispielsweise über Höhen oder der gleichen einem solchen Plan nicht entnehmbar sind, können diese mit herkömmlich bekannten Mitteln ergänzt werden.

Figur 2 zeigt beispielhaft einen Ablauf des erfindungsgemäßen Verfahrens. Nach dem Start 2 wird in der nächsten Stufe der digitale Plan 3 des elektrisch zu planenden Raumes oder Gebäudes eingelesen. Weiterhin erfolgt die Erfassung individueller Vorgaben 4.

Im Vergleich 5 wird der digitale Plan 3 mit gespeicherten oder ermittelbaren digitalen Vorlagen 6 verglichen. Es erfolgt die Auswahl einer dem digitalen Plan 3 am nächsten kommenden digitalen Vorlage 6, aus welcher die Standard-Elektrifizierung 7 eines solchen räumlichen Bereiches ermittelt wird.

In der Korrektur 8 wird die Standard-Elektrifizierung unter Berücksichtigung der individuellen Vorgaben 4 überarbeitet, sodass sich schließlich die geplante Elektrifizierung 9 ergibt.

Die Erfassung der individuellen Vorgaben 4 kann auch erst in der Phase der Korrektur 8 erfolgen, anstelle der Erfassung nach dem Start 2 beim einlesen des digitalen Planes 3.

## Patentansprüche

1. Verfahren zur automatischen Erstellung eines Planes für eine Elektroinstallation in wenigstens einem Raum, unter Nutzung eines Systems, welches über eine Rechnereinheit verfügt mit einer Speichereinheit, auf der eine Datenbank mit Vorlagen von Elektroinstallationen für Raumtypen gespeichert ist, und mit Ein- und Ausgabeeinheiten, wobei eine digitalisierte Version der räumlichen Dimensionierungen des Raumes, für den der Plan erstellt werden soll, erfasst und mit den in der Datenbank vorhandenen Raumtypen verglichen wird, eine geeignete Vorlage ausgewählt und auf die konkreten räumlichen Dimensionierungen des Raumes angepasst wird und eine digitale Version der räumlichen Dimensionierungen des Raumes mit der angepassten Elektroinstallation aus der Vorlage versehen und als Datei gespeichert wird.

2. Verfahren nach Anspruch 1, **dadurch gekennzeichnet, dass** der Plan für eine Elektroinstallation für eine Gebäudeeinheit erstellt wird.

3. Verfahren nach einem der vorhergehenden Ansprüche, **dadurch gekennzeichnet, dass** als digitalisierte Version der räumlichen Dimensionierungen Grundrisse verwendet werden.

4. Verfahren nach einem der vorhergehenden Ansprüche, **dadurch gekennzeichnet, dass** bei der Planung zusätzliche Daten wie Raumhöhe, Öffnungen durch Türen, Fenster, Lüftungen und dergleichen sowie vorgesehene Funktionalitäten des Raumes berücksichtigt werden.

5. Verfahren nach einem der vorhergehenden Ansprüche, **dadurch gekennzeichnet, dass** der gespeicherte Plan fachmännisch überprüft und aktualisiert wird.

6. Verfahren nach einem der vorhergehenden Ansprüche, **dadurch gekennzeichnet, dass** erstellte Pläne als Vorlagen in die Datenbank übernommen werden.

7. Verfahren nach einem der vorhergehenden Ansprüche, **dadurch gekennzeichnet, dass** der Plan für die Elektroinstallation als Zeichnung mit Symbolen für Leitungen und elektrische Funktionseinheiten wie Schalter, Steckdosen, Sicherungen erstellt wird.

8. Verfahren nach einem der vorhergehenden Ansprüche, **dadurch gekennzeichnet, dass** der Plan für die Elektroinstallation um eine Stückliste ergänzt wird.

9. Verfahren nach Anspruch 8, **dadurch gekennzeichnet, dass** die Stückliste verwendet wird, um automatisch Preisinformationen von vorgegebenen Bezugsquellen zu ergänzen.

10. System zur automatischen Erstellung eines Planes für eine Elektroinstallation in wenigstens einem Raum, wobei das System über eine Rechnereinheit verfügt mit einer Speichereinheit, auf der eine Datenbank mit Vorlagen von Elektroinstallationen für Raumtypen gespeichert ist, und mit Ein- und Ausgabeeinheiten, wobei das System eine digitalisierte Version der räumlichen Dimensionierungen des Raumes, für den der Plan erstellt werden soll, erfasst und mit den in der Datenbank vorhandenen Raumtypen vergleicht, eine geeignete Vorlage ausgewählt und auf die konkreten räumlichen Dimensionierungen des Raumes anpasst und eine digitale Version der räumlichen Dimensionierungen des Raumes mit der angepassten Elektroinstallation aus der Vorlage versieht und als Datei speichert.
